# EUROPEAN PATENT APPLICATION

(11) **EP 4 645 385 A2**
(43) Date of publication of application: **05.11.2025**
(21) Application number: 25167356.2
(22) Date of filing: 31.03.2025
(51) Int. Cl.: H01L 23/48, H01L 23/522

(54) **INTEGRATED CIRCUIT INCLUDING THROUGH SILICON VIAS**

(30) Priority: 03.05.2024 KR 20240059405; 20.09.2024 KR 20240127532
(71) Applicant: Samsung Electronics Co., Ltd., Suwon-si, Gyeonggi-do 16677 (KR)
(72) Inventor: JUNG, Yeonil, 16677 Suwon-si (KR); KIM, Hankyung, 16677 Suwon-si (KR); LEE, Seungkwon, 16677 Suwon-si (KR)
(74) Representative: Marks & Clerk LLP

(57) **Abstract**

Integrated circuits are provided. In one aspect, an integrated circuit includes: a plurality of first active patterns positioned in a first region and extending in a first horizontal direction on a substrate; a through silicon via positioned in the first region and vertically extending through the substrate and at least one of the plurality of first active patterns; and a plurality of first diffusion breaks position in the first region, the plurality of first diffusion breaks extending in a second horizontal direction and dividing the plurality of first active patterns.

## Description

### BACKGROUND

To meet the need for high integration, integrated circuits may include a through silicon via. The through silicon via may penetrate a substrate on which devices such as transistors are formed. The through silicon via may be used for connection to other chips (or dies), and multiple chips interconnected through the through silicon via may be included in a single package. With the progress in the semiconductor processes, the size of devices included in an integrated circuit may be reduced, and the devices may become sensitive to the through silicon via. Accordingly, protecting devices from the through silicon via may be desired.

### SUMMARY

The present disclosure provides an integrated circuit with reduced impact due to a through silicon via.

According to an aspect of the present disclosure, an integrated circuit is provided, including: a plurality of first active patterns positioned in a first region of a substrate and extending in a first horizontal direction; a through silicon via positioned in the first region and vertically penetrating the substrate and at least one of the plurality of first active patterns; and a plurality of first diffusion breaks positioned in the first region, the plurality of first diffusion breaks extending in a second horizontal direction and dividing the plurality of first active patterns.

According to another aspect of the present disclosure, an integrated circuit is provided, including: a plurality of first active patterns extending in a first horizontal direction a substrate; a plurality of first diffusion breaks extending in a second horizontal direction, the plurality of first diffusion breaks dividing the plurality of first active patterns; a through silicon via vertically extending though the substrate and at least one of the plurality of first active patterns; and a dam structure surrounding the through silicon via, where the dam structure includes a plurality of first patterns respectively arranged in a plurality of wiring layers on the substrate and a plurality of first vias respectively arranged in a plurality of via layers between corresponding wiring layers of the plurality of wiring layers, and each of the plurality of first vias interconnects two adjacent first patterns of the plurality of first patterns.

According to another aspect of the present disclosure, an integrated circuit is provided, including: a plurality of first regions, each of the plurality of first regions including: a plurality of first active patterns extending in a first horizontal direction on a substrate; a plurality of through silicon vias each vertically extending through at least one of the plurality of first active patterns and the substrate; and a plurality of first diffusion breaks extending in a second horizontal direction and dividing the plurality of first active patterns.

At least some of the above and other features of the invention are set out in the claims.

### BRIEF DESCRIPTION OF THE DRAWINGS

Implementations will be more clearly understood from the following detailed description taken in conjunction with the accompanying drawings in which:
FIG. 1 is a diagram illustrating an example of a layout of an integrated circuit according to an implementation;
FIGS. 2A to 2D are diagrams illustrating examples of a transistor according to implementations;
FIG. 3 is a diagram illustrating an example of layout of an integrated circuit according to an implementation;
FIGS. 4A to 4C are diagrams illustrating examples of a layout of an integrated circuit according to implementations;
FIG. 5 is a diagram illustrating an example of layout of an integrated circuit according to an implementation;
FIG. 6 is a diagram illustrating an example of a layout of an integrated circuit according to an implementation;
FIG. 7 is a diagram illustrating an example of a layout of an integrated circuit according to an implementation;
FIGS. 8A to 8C are diagrams illustrating examples of a layout of an integrated circuit according to implementations;
FIG. 9 is a diagram illustrating an example of a layout of an integrated circuit according to an implementation;
FIG. 10 is a diagram illustrating an example of a dam structure according to an implementation;
FIG. 11 is a diagram illustrating an example of a layout of an integrated circuit according to an implementation;
FIG. 12 is a diagram illustrating an example of a layout of an integrated circuit according to an implementation;
FIG. 13 is a diagram illustrating an example of a layout of an integrated circuit according to an implementation; and
FIG. 14 is a diagram illustrating an example of a memory device according to an implementation.

### DETAILED DESCRIPTION OF THE EMBODIMENTS

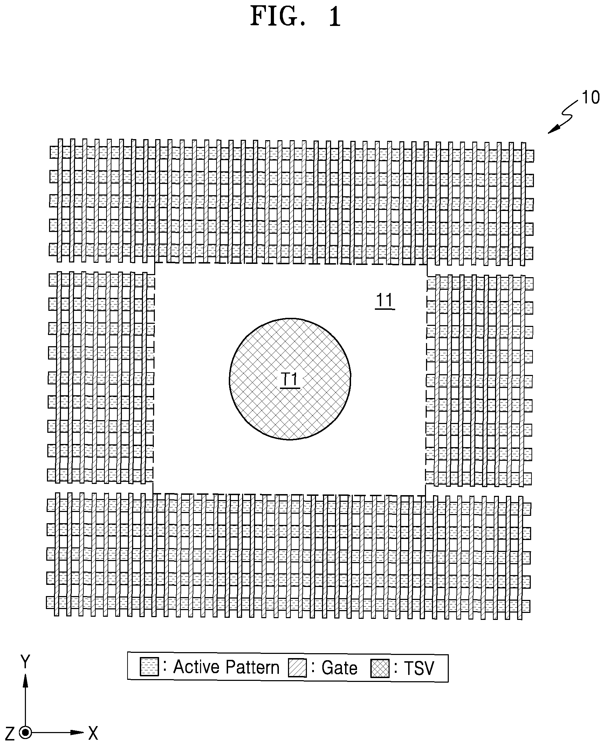

FIG. 1 is a diagram illustrating a layout of an integrated circuit 10 according to an implementation. For example, FIG. 1 illustrates a portion of a layout including a through silicon via T1 in the integrated circuit 10 as viewed from a plane including an X-axis and a Y-axis. In the present specification, an X-axis direction and a Y-axis direction may be referred to as a first direction (or a first horizontal direction) and a second direction (or a second horizontal direction), respectively, and a Z-axis direction may be referred to as a vertical direction or a third direction. The X-axis direction may cross (e.g. may be perpendicular to) the Y-axis direction. The Z-axis direction may cross (e.g. may be perpendicular to) the X-axis direction and the Y-axis direction. A plane formed by the X-axis and the Y-axis may be referred to as a horizontal plane, and a component positioned in a +Z direction relative to other components may be referred to as being above other components, and a component positioned in a -Z direction relative to other components may be referred to as being below other components. Additionally, an area of a component may refer to a size that the component occupies in a plane parallel to the horizontal plane, and a width of a component may refer to a length of the component in a direction orthogonal to a direction in which the component extends. A surface exposed in the +Z direction may be referred to as a top surface, a surface exposed in the -Z direction may be referred to as a bottom surface, and a surface exposed in the ±X direction or ±Y direction may be referred to as a side surface. A substrate of the integrated circuit 10 may extend in the X and Y directions (e.g. in the horizontal plane). It will be appreciated that these directions (e.g. horizontal, vertical, etc.) and relative positions (e.g. above, below, etc.) are defined relative to the structure of the device, and need not imply any particular orientation of the device, in use. In the drawings of the present specification, only some layers may be illustrated for convenience of illustration, and vias connecting an upper pattern to a lower pattern may be indicated for understanding, even though the vias are located under the upper pattern. Additionally, a pattern including a conductive material, such as a pattern of a wiring layer, may be referred to as a conductive pattern or may simply as a pattern.

The integrated circuit 10 may be manufactured by a semiconductor process including a series of sub-processes. For example, a plurality of layers may be patterned using masks on a wafer including a plurality of chips (or dies), and a chip (or die) including the integrated circuit 10 may be manufactured. Front-end-of-line (FEOL) may include, for example, operations of planarizing and cleaning a wafer, forming a trench, forming a well, forming a gate electrode, and forming a source and a drain. In FEOL, individual devices, such as transistors, capacitors, resistors, etc., may be formed on a substrate. Back-end-of-line (BEOL) may include operations such as silicidating gate, source and drain regions, adding a dielectric, planarizing, forming holes, adding a metal layer, forming a via, forming a passivation layer, etc. In BEOL, individual devices such as transistors, capacitors, resistors, etc. may be interconnected. In some implementations, middle-of-line (MOL) may be performed between FEOL and BEOL, and in MOL, contacts may be formed on individual devices. Next, the integrated circuit 10 may be packaged in a semiconductor package and used as a component in various applications. In the present specification, structures formed by FEOL, MOL and BEOL may be simply referred to as FEOL, MOL and BEOL, respectively.

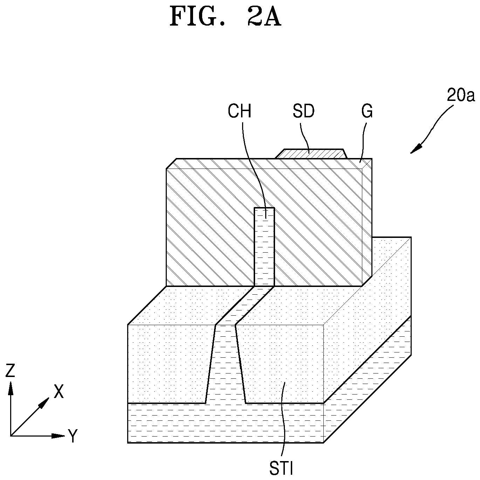

Referring to FIG. 1, the integrated circuit 10 may include a plurality of active patterns extending in the X-axis direction and a plurality of gate electrodes extending in the Y-axis direction. An active pattern extending in the X-axis direction and a gate electrode (or gate) extending in the Y-axis direction may intersect with each other and form a transistor as a device. A transistor may function as a portion of various circuits. For example, a transistor may be included in a digital circuit, such as a logic gate or a flip-flop, may be included in a memory cell, or may be included in an analog circuit, such as an amplifier. Examples of the transistor as a device formed by active patterns and gate electrodes is described below with reference to FIGS. 2A to 2D.

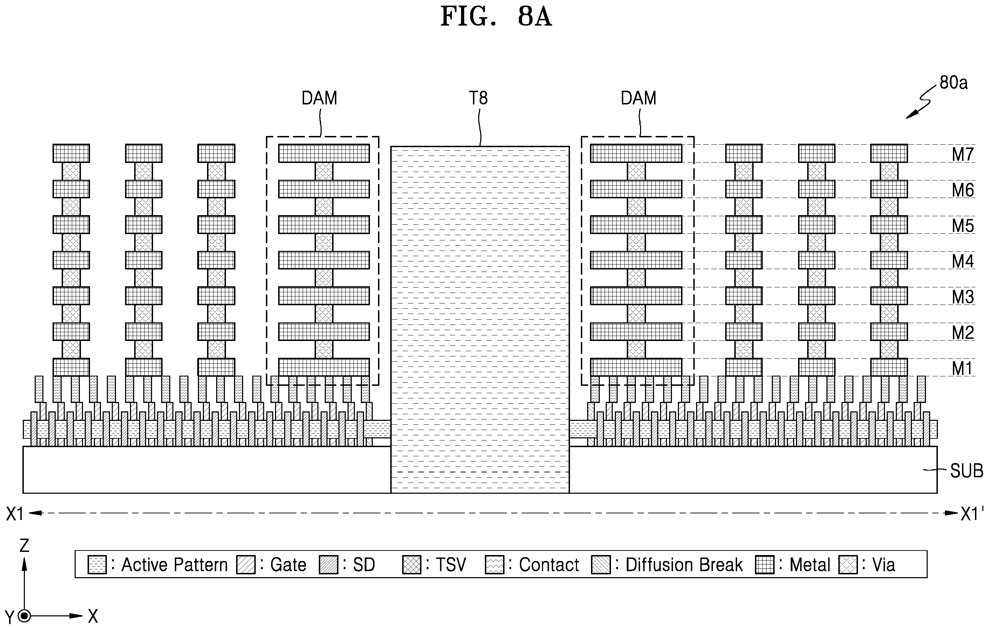

The through silicon via T1 may penetrate, in the Z-axis direction, a substrate on which devices are formed, as described below with reference to FIG. 8A, etc. A cross-section of the through silicon via T1 is not limited to a circle as illustrated in FIG. 1. The through silicon via T1 may be used to connect nodes of the integrated circuit 10 to nodes of another chip, or may be used for interconnection between nodes of other chips. The through silicon via T1 may affect peripheral devices. For example, due to sub-processes for forming the through silicon via T1, a structure and/or composition of devices formed around the through silicon via T1 may be changed. In particular, devices with a reduced size due to advancements in semiconductor processes may be sensitive to the effects of the through silicon via T1. Accordingly, the devices arranged around the through silicon via T1 may not provide designed performance, resulting in deterioration in the performance and/or reliability of the integrated circuit 10.

To reduce the impact of the through silicon via T1, the integrated circuit 10 may include a keep out zone (KOZ) 11. For example, as illustrated in FIG. 1, the KOZ 11 may include a region where the through silicon via T1 is arranged. In the KOZ 11, active patterns and gate electrodes may be omitted and devices may not be formed. For example, KOZ 11 may be free of the active patterns. For example, KOZ 11 may be free of the gate electrodes. When the KOZ 11 is extended by taking into account the impact of the through silicon via T1, the area of the integrated circuit 10 may be increased. Additionally, devices adjacent to the KOZ 11 may still have different characteristics from devices spaced apart from the KOZ 11.

As described below with reference to the drawings, an integrated circuit may include a structure that reduces the impact of through silicon vias. Accordingly, integrated circuits including through silicon vias and devices may provide high reliability as well as designed performance. Additionally, due to the reduced impact of the through silicon vias, the area required for a through silicon via, i.e., the area of a KOZ, may be reduced, thereby increasing the efficiency of the integrated circuit. In addition, a structure that reduces the impact of through silicon vias may be implemented without additional processes, and thus an integrated circuit including a through silicon via may be easily manufactured at low cost.

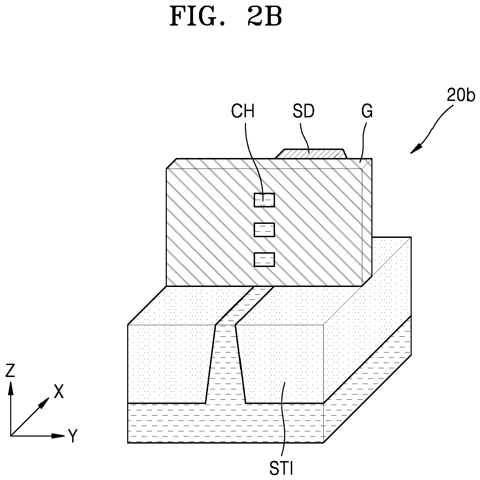

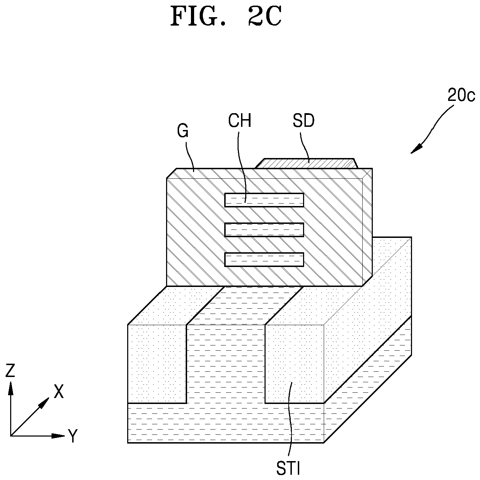

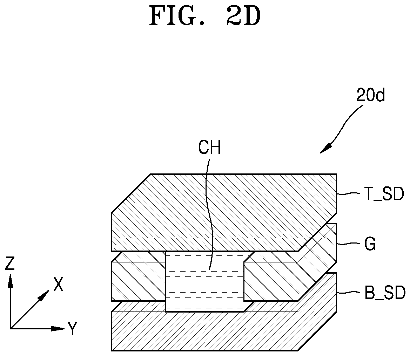

FIGS. 2A to 2D are diagrams illustrating examples of a transistor according to implementations. For example, FIG. 2A illustrates a fin field-effect transistor (FinFET) 20a, FIG. 2B illustrates a gate-all-around field effect transistor (GAAFET) 20b, FIG. 2C illustrates a multi-bridge channel field effect transistor (MBCFET) 20c, and FIG. 2D illustrates a vertical field effect transistor (VFET) 20d. For convenience of illustration, FIGS. 2A to 2C illustrate a state in which one of two source/drain regions is removed, and FIG. 2D illustrates a cross-section of the VFET 20d cut along a plane parallel to the Y-axis and the Z-axis and passing through a channel CH of the VFET 20d.

Referring to FIG. 2A, the FinFET 20a may be formed by a fin-shaped active pattern extending in the X-axis direction between shallow trench isolations (STI) and a gate G extending in the Y-axis direction. A source/drain SD may be formed on opposite sides of the gate G, and thus a source and a drain may be spaced apart from each other in the X-axis direction. An insulating film may be formed between the channel CH and the gate G. In some implementations, the FinFET 20a may be formed by a plurality of active patterns and the gate G spaced apart from each other in the Y-axis direction.

Referring to FIG. 2B, the GAAFET 20b may be formed by active patterns, i.e. nanowires, extending in the X-axis direction and spaced apart from each other in the Z-axis direction, and a gate G extending in the Y-axis direction. The source/drain SD may be formed on opposite sides of the gate G, and thus the source/drain SD may be spaced apart from each other in the X-axis direction. An insulating film may be formed between the channel CH and the gate G. The number of nanowires included in the GAAFET 20b is not limited to that illustrated in FIG. 2B.

Referring to FIG. 2C, the MBCFET 20c may be formed by active patterns extending in the X-axis direction and spaced apart from each other in the Z-axis direction, i.e. nanosheets, and the gate G extending in the Y-axis direction. The source/drain SD may be formed on opposite sides of the gate G, and thus a source and a drain may be spaced apart from each other in the X-axis direction. An insulating film may be formed between the channel CH and the gate G. The number of nanosheets included in the MBCFET 20c is not limited to that illustrated in FIG. 2C.

Referring to FIG. 2D, the VFET 20d may include a top source/drain T_SD and a bottom source/drain B_SD spaced apart from each other in the Z-axis direction with the channel CH therebetween. The VFET 20d may include the gate G surrounding the channel CH between the top source/drain T_SD and the bottom source/drain B_SD. An insulating film may be formed between the channel CH and the gate G.

Hereinafter, for convenience of description, an integrated circuit including an MBCFET including a single nanosheet will be mainly described, but devices included in the integrated circuit are not limited to the examples of FIGS. 2A to 2D. For example, the integrated circuit may include a ForkFET in which an N-type transistor and a P-type transistor are relatively close to each other because nanosheets for the P-type transistor and nanosheets for the N-type transistor are separated from each other by a dielectric wall. Additionally, the integrated circuit may include bipolar junction transistors as well as FETs, such as complementary field effect transistors (CFETs), negative capacitance field effect transistors (NCFETs), and carbon nanotube (CNT) FETs.

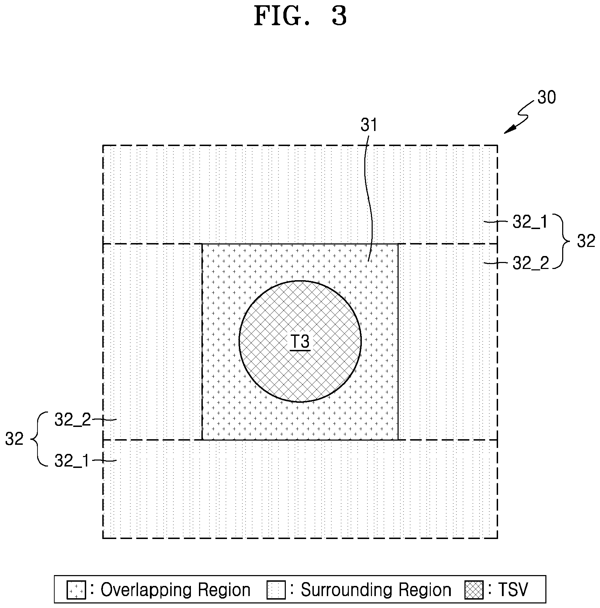

FIG. 3 is a diagram illustrating a layout of an integrated circuit 30 according to an implementation. For example, FIG. 3 illustrates a portion of a layout including a through silicon via T3 in the integrated circuit 30 as viewed from a plane including the X-axis and the Y-axis. As described above with reference to FIG. 1, a KOZ may be defined by taking into account the impact of the through silicon via T3.

Referring to FIG. 3, the KOZ may include an overlapping region 31 including a region where the through silicon via T3 penetrates a substrate and a surrounding region 32 surrounding the overlapping region 31. Additionally, the surrounding region 32 may include a first sub-region 32_1 adjacent to the overlapping region 31 in the Y-axis direction and a second sub-region 32_2 adjacent to the overlapping region 31 in the X-axis direction. As illustrated in FIG. 3, the overlapping region 31 may include a portion that actually overlaps with the through silicon via T3 and a margin. In the present specification, the overlapping region 31 and the surrounding region 32 may be referred to as a first region and a second region, respectively.

Unlike the KOZ 11 of FIG. 1, from which the active pattern and the gate electrodes are removed, the active patterns may extend in the X-axis direction in the overlapping region 31 and the surrounding region 32. Additionally, the gate electrodes may be omitted in the overlapping region 31, while gate electrodes may extend in the Y-axis direction in the surrounding region 32. For example, the overlapping region 31 may be free of the gate electrodes. Accordingly, due to the active patterns and the gate electrodes formed inside a KOZ in the same manner as outside the KOZ, the structure (e.g., pitch, size, etc.) and/or composition of devices adjacent to the KOZ (i.e., devices adjacent to the surrounding region 32) may be maintained despite the formation of the through silicon via T3, and the devices may provide the designed performance and high reliability. In the present specification, devices formed by active patterns and gate electrodes within a KOZ may be referred to as dummy devices. In some implementations, electrodes of the dummy devices may be electrically floated. Examples of the overlapping region 31 and the surrounding region 32 will be described below with reference to the drawings. In the present disclosure, the KOZ may be referred to as a via zone, and the region outsize of the KOZ may be referred to as a device zone. Unlike the devices in the KOZ zone, the devices formed by active patterns and gate electrodes in the device zone may be functioning devices (e.g., not dummy devices).

According to some implementations, the via zone may include the overlapping region 31 and the surrounding region 32, and the device zone may surround the via zone. For example, the overlapping region 31 may include a plurality of first active patterns, and the device zone may include a plurality of second active patterns. For example, a pitch of the plurality of second active patterns may be equal to a pitch of the plurality of first active patterns. For example, the surrounding region 32 may include a plurality of first gate electrodes, and the device zone may includes a plurality of second gate electrodes. For example, a pitch of the plurality of second gate electrodes may be equal to a pitch of the plurality of first gate electrodes. In the present specification, pitch may refer to the center-to-center spacing of adjacent, repeating features (e.g. active patterns, gate electrodes, etc.).

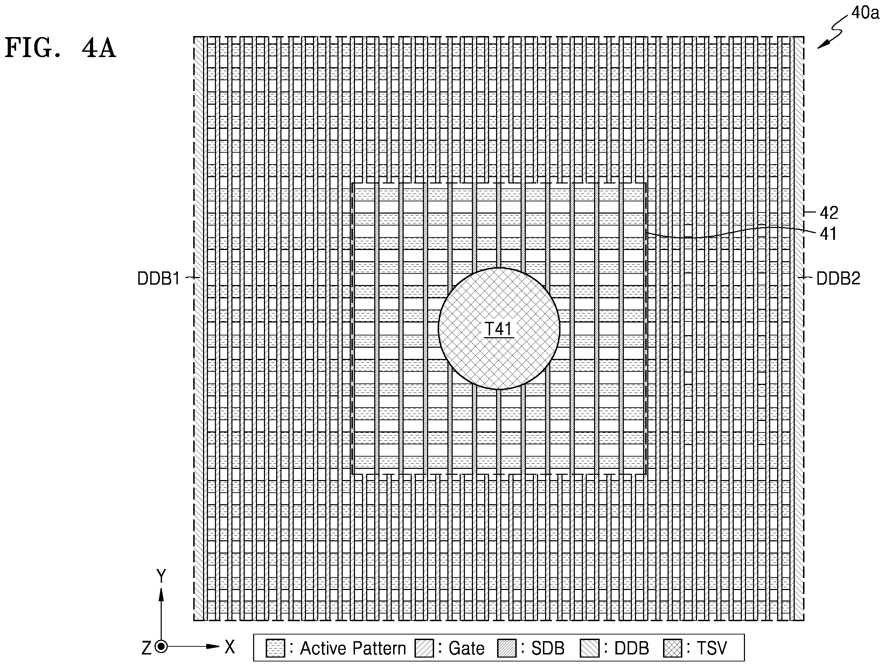

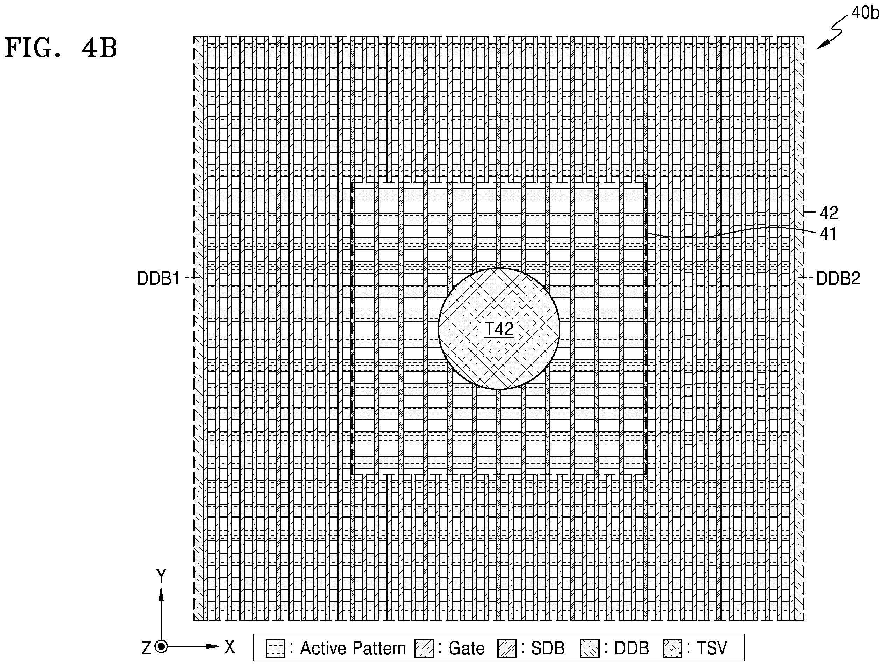

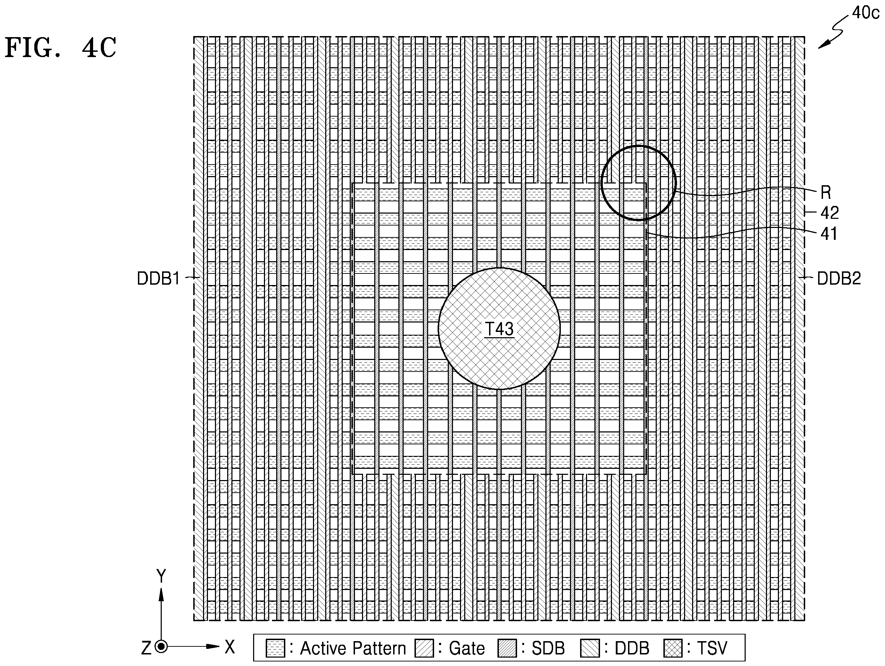

FIGS. 4A to 4C are diagrams illustrating examples of a layout of an integrated circuit according to implementations. For example, FIG. 4A illustrates a portion of a layout including a through silicon via T41 in an integrated circuit 40a, FIG. 4B illustrates a portion of a layout including a through silicon via T42 in an integrated circuit 40b, and FIG. 4C illustrates a portion of a layout including a through silicon via T43 in an integrated circuit 40c. As described above with reference to FIG. 3, each of the through silicon vias T41, T42, and T43 may penetrate a substrate in an overlapping region 41, and a surrounding region 42 may surround the overlapping region 41. Details of the description with reference to FIGS. 4A to 4C provided above will be omitted.

Referring to FIG. 4A, the integrated circuit 40a may include a plurality of active patterns extending in the X-axis direction in the overlapping region 41 (which may be referred to as a plurality of first active patterns in the present specification). The through silicon via T41 may penetrate at least one of the plurality of active patterns and the substrate in the Z-direction in the overlapping region 41. The plurality of active patterns extending in the overlapping region 41 may be divided by diffusion breaks extending in the Y-axis direction. A diffusion break may include an insulating material and may divide the active patterns from each other to provide insulation between the divided active patterns. The diffusion break may include a single diffusion break SDB in which an insulating material is filled to replace a gate electrode and a double diffusion break DDB in which a space between adjacent gate electrodes is filled with an insulating material. In some implementations, as illustrated in FIG. 4A, single diffusion breaks extending in the Y-axis direction in the overlapping region 41 may divide a plurality of active patterns from each other.

The integrated circuit 40a may include, in the surrounding region 42, a plurality of active patterns extending in the X-axis direction and a plurality of gate electrodes extending in the Y-axis direction. As illustrated in FIG. 4A, a plurality of gate electrodes may extend in the Y-axis direction at a constant pitch. In some implementations, a pitch of the single diffusion breaks extending in the Y-axis direction in the overlapping region 41 may be different from a pitch of the gate electrodes extending in the Y-axis direction in the surrounding region 42. In the overlapping region 41, the gate electrodes may be omitted, thereby preventing electrical connection between the through silicon via T41 and the gate electrodes. Additionally, the integrated circuit 40a may include a diffusion break extending along a boundary of the surrounding region 42. For example, as illustrated in FIG. 4A, a first double diffusion break DDB1 and a second double diffusion break DDB2 may extend in the Y-axis direction along the boundary of the surrounding region 42.

In some implementations, single diffusion breaks SDB may replace corresponding gate electrodes in the overlapping region 41. Accordingly, each single diffusion break SDB may align with a corresponding gate electrode in the surrounding region 42. The width (e.g. in the X-axis direction) of the single diffusion breaks SDB may be equal (e.g. substantially equal) to the width (e.g. in the X-axis direction) of the gate electrodes in the surrounding region 42. The pitch of the single diffusion breaks in the overlapping region 41 may be greater than or equal to the pitch of the gate electrodes in the surrounding region 42. The pitch of the single diffusion breaks in the overlapping region 41 may be an integer multiple of the pitch of the gate electrodes in the surrounding region 42.

In some implementations, the active patterns in the overlapping region 41 and the surrounding region 42 may follow the same rules as the active patterns outside the surrounding region 42. For example, the active patterns in the overlapping region 41 and the surrounding region 42 may have the same widths, pitches, and conductivity type as external active patterns adjacent to the surrounding region 42. For example, the active patterns in the overlapping region 41 may be aligned in the X-axis direction with corresponding active patterns in the surrounding region 42. Active patterns of the surrounding region 42 may extend into the overlapping region 41. Accordingly, continuous active patterns may be maintained, and devices positioned adjacent to the surrounding region 42 may be unaffected by sub-processes of forming the through silicon via T41. In some implementations, the gate electrodes in the surrounding region 42 may follow the same rules as gate electrodes outside the surrounding region 42. For example, the gate electrodes in the surrounding region 42 may have the same widths, pitches, and composition as the external gate electrodes adjacent to the surrounding region 42. For example, the gate electrodes of the surrounding region 42 may be aligned in the Y-axis direction with corresponding gate electrodes (external gate electrodes) in the device zone (e.g. the region adjacent to and surrounding the surrounding region 42). Gate electrodes of the device zone may extend into the surrounding region 42. Accordingly, continuous gate electrodes may be maintained, and devices positioned adjacent to the surrounding region 42 may be unaffected by sub-processes of forming the through silicon via T41. In addition, due to the active patterns and the gate electrodes in the overlapping region 41 and/or the surrounding region 42, the density of the active patterns and the gate electrodes in a layout of the integrated circuit 40a may be maintained uniform, and reliability of the integrated circuit 40a may be improved.

Referring to FIG. 4B, the integrated circuit 40b may further include single diffusion breaks extending in the Y-axis direction in the surrounding region 42. For example, as illustrated in FIG. 4B, single diffusion breaks may extend in the Y-axis direction in the surrounding region 42, and gate electrodes may extend in the Y-axis direction between adjacent single diffusion breaks. A pitch between a single diffusion break in the surrounding region 42 and the gate electrodes adjacent to the single diffusion break in the surrounding region 42 may be the same as a pitch between adjacent gate electrodes. In some implementations, as illustrated in FIG. 4B, some of the single diffusion breaks extending in the Y-axis direction in the surrounding region 42 may be aligned in the Y-axis direction with at least some of the single diffusion breaks extending in the Y-axis direction in the overlapping region 41. The pitch of the single diffusion breaks in the surrounding region 42 may be greater than or equal to the pitch of the single diffusion breaks in the overlapping region 41. The pitch of the single diffusion breaks in the surrounding region 42 may be an integer multiple of the pitch of the single diffusion breaks in the overlapping region 41.

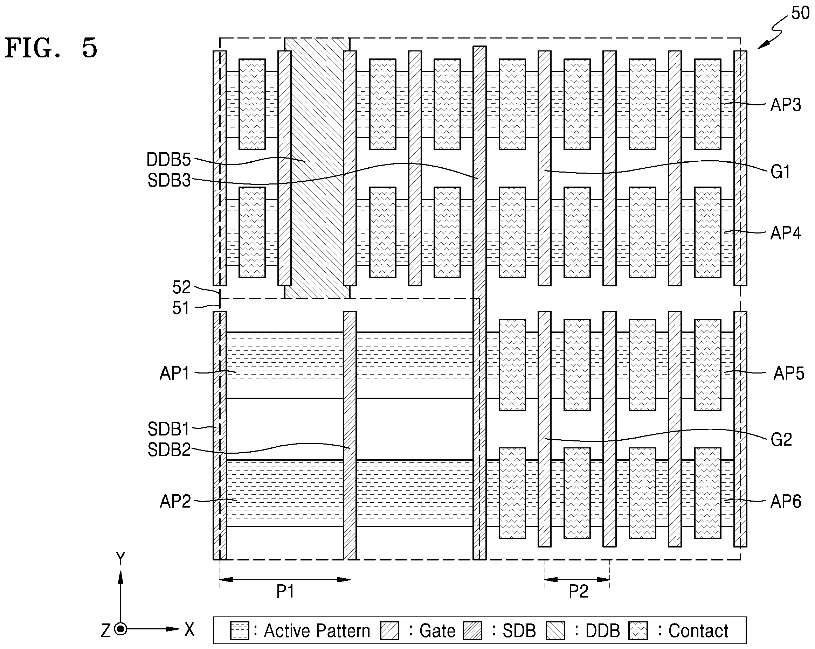

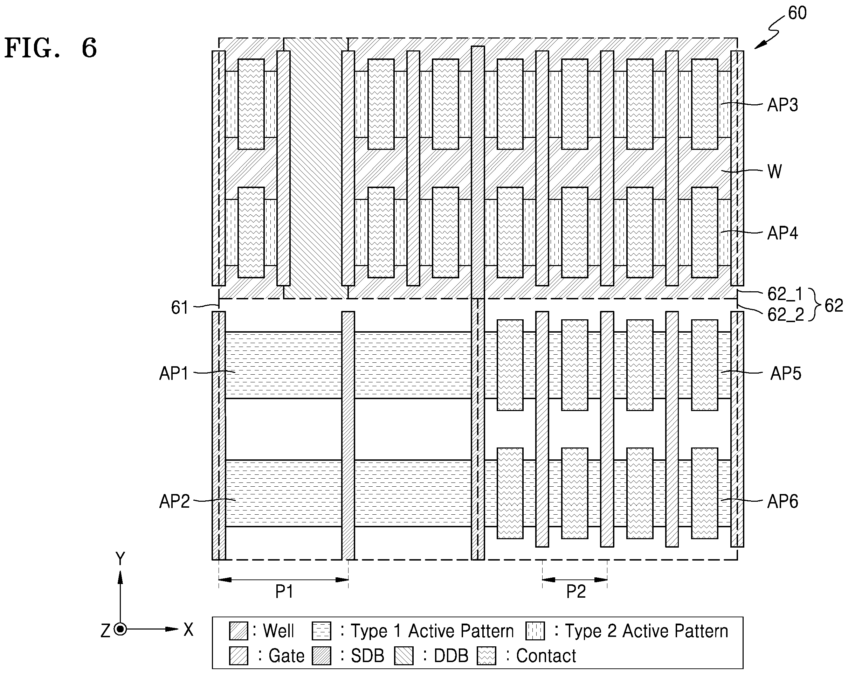

Referring to FIG. 4C, the integrated circuit 40c may further include double diffusion breaks extending in the Y-axis direction within the surrounding region 42. For example, the integrated circuit 40c may include the first double diffusion break DDB1 and the second double diffusion break DDB2 extending in the Y-axis direction along the boundary of the surrounding region 42, as well as double diffusion breaks extending in the Y-axis direction within the surrounding region 42. In some implementations, double diffusion breaks may extend in the Y-axis direction between adjacent gate electrodes. Below, a region R of FIG. 4C is described with reference to FIGS. 5 and 6.

FIG. 5 is a diagram illustrating a layout of an integrated circuit 50 according to an implementation. For example, FIG. 5 illustrates a portion of an overlapping region 51 and a surrounding region 52 in the integrated circuit 50 as an example of the region R of FIG. 4C. In the description with reference to FIG. 5, description that is substantially the same as the description given above with reference to the drawings will be omitted.

Referring to FIG. 5, in the overlapping region 51, active patterns AP1 and AP2 may extend in the X-axis direction, and the active patterns AP1, AP2 may be divided by single diffusion breaks SDB1 and SDB2 extending in the Y-axis direction at a first pitch P1. The single diffusion breaks SDB1 and SDB2 may be arranged in the X-axis direction at the first pitch P1. Additionally, active patterns AP3 to AP6 in the surrounding region 52 may extend in the X-axis direction. As illustrated in FIG. 5, among the active patterns AP3 to AP6 of the surrounding region 52, the active patterns AP5 and AP6 adjacent to the overlapping region 51 in the X-axis direction may be aligned in the X-axis direction with the active patterns AP1, AP2 of the overlapping region 51.

In the surrounding region 52, gate electrodes may extend in the Y-axis direction, arranged at a second pitch P2 in the X-axis direction, while in the overlapping region 51, the gate electrodes may be omitted. The second pitch P2 of the gate electrodes may be referred to as contacted poly pitch (CPP). A contacted poly pitch may be a pitch (e.g. a center to center distance) between two adjacent gate electrodes (e.g. polysilicon (poly) gates) separated by a source/drain region (e.g. for the transistors in the device zone). In some implementations, the first pitch P1 of the single diffusion breaks SDB1 and SDB2 in the overlapping region 51 may be different from the second pitch P2 of the gate electrodes in the surrounding region 52. For example, as illustrated in FIG. 5, the first pitch P1 may correspond to the second pitch P2, i.e., twice the CPP. Contacts, i.e. source/drain contacts, may extend in the Y-axis direction between the gate electrodes in the surrounding region 52. In some implementations, the gate electrodes in the surrounding region 52 may be separated into portions aligned in the Y-axis direction. For example, as illustrated in FIG. 5, a first gate electrode G1 and a second gate electrode G2 may be separated from each other and aligned with each other in the Y-axis direction. Additionally, as described above with reference to FIGS. 4B and 4C, a single diffusion break SDB3 and a double diffusion break DDB5 may extend in the Y-axis direction in the surrounding region 52.

FIG. 6 is a diagram illustrating a layout of an integrated circuit 60 according to an implementation. For example, FIG. 6 illustrates a portion of an overlapping region 61 and a surrounding region 62 in the integrated circuit 60 as an example of the region R of FIG. 4C. As described above with reference to FIG. 3, the surrounding region 62 may include a first sub-region 62_1 adjacent to the overlapping region 61 in the Y-axis direction and a second sub-region 62_2 adjacent to the overlapping region 61 in the X-axis direction. In the description with reference to FIG. 6, description that is substantially the same as the description given above with reference to the drawings will be omitted.

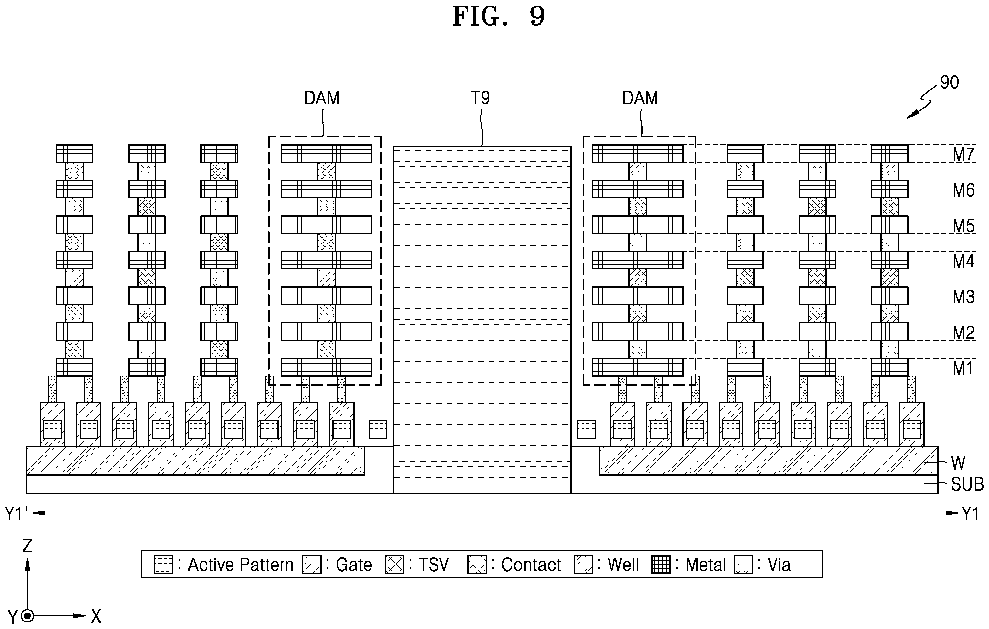

In some implementations, a well may be omitted in the overlapping region 61. The integrated circuit 60 may include a substrate having one conductivity type, and wells of different conductivity types from that of the substrate may be disposed on the substrate to form different types of devices on the substrate, such as an n-channel field effect transistor (NFET) and a p-channel field effect transistor (PFET), as described below with reference to FIG. 9. Accordingly, active patterns extending on the substrate and active patterns extending on the well may have different conductive types and may form different types of devices, respectively. By omitting the well in the overlapping region 61, a through silicon via may penetrate the substrate without penetrating the well, thereby allowing the through silicon via to be formed in a simple manner. Due to the well omitted in the overlapping region 61, active patterns extending in the X-axis direction in the overlapping region 61 may have the same conductivity type. For example, as illustrated in FIG. 6, the active patterns AP1 and AP2 may have a first conductivity type (e.g. p-type or n-type). In some implementations, the substrate may have the first conductivity type. The first conductivity type may be p-type.

In some implementations, the active patterns extending in the X-axis direction in the first sub-region 62_1 of the surrounding region 62 may have a different conductivity type from that of the active patterns in the overlapping region 61. As described above, the active patterns AP1, AP2 of the first conductivity type may extend in the overlapping region 61 due to the well omitted in the overlapping region 61, and accordingly, the active patterns AP3, AP4 extending in the first sub-region 62_1 of the surrounding region 62 may have a second conductivity type different from the first conductivity type so that the active patterns in the integrated circuit 60 have balanced conductivity types. To this end, a well W having the second conductivity type may be arranged on the substrate in the first sub-region 62_1 of the surrounding region 62, and the active patterns AP3, AP4 may extend in the X-axis direction on the well W. Accordingly, problems in a semiconductor process that may occur due to imbalance of the conductivity types of active patterns may be prevented, and reliability of the integrated circuit 60 may be improved. In some implementations, the second conductivity type may be n-type and the well W may be an n-well.

In some implementations, the active patterns extending in the X-axis direction in the second sub-region 62_2 of the surrounding region 62 may have the same conductivity type as the active patterns in the overlapping region 61. For example, as illustrated in FIG. 6, the active patterns AP5, AP6 may have the first conductive type and may be formed simultaneously with the active patterns AP1, AP2 of the overlapping region 61 by a semiconductor process. In some implementations, differently from that illustrated in FIG. 6, the well W may extend into the second sub-region 62_2, and the active patterns AP5, AP6 extending in the X-axis direction in the second sub-region 62_2 may have the second conductivity type different from that of the active patterns AP1, AP2 of the overlapping region 61.

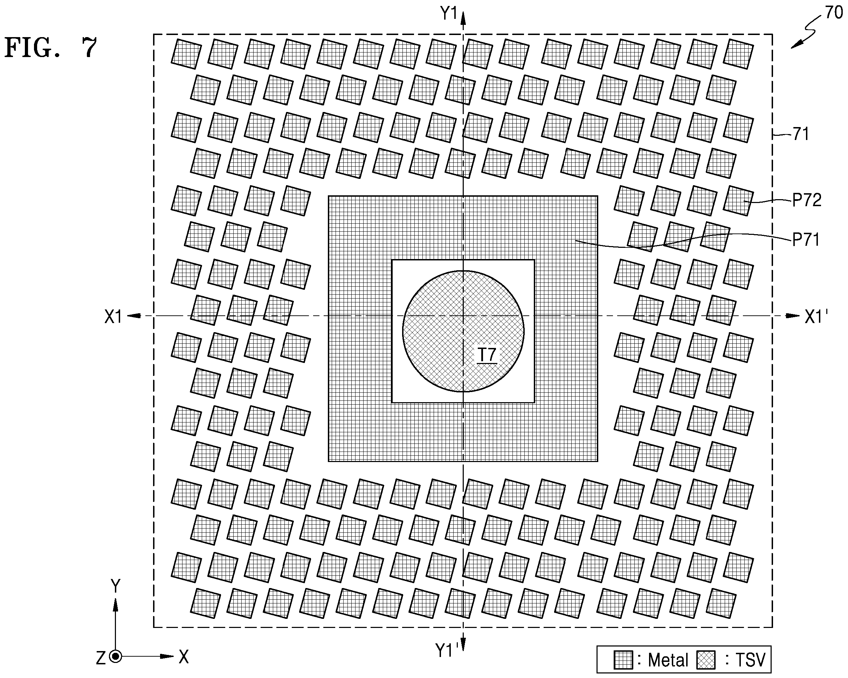

FIG. 7 is a diagram illustrating a layout of an integrated circuit 70 according to an implementation. For example, FIG. 7 illustrates a portion of a layout including a through silicon via T7 in the integrated circuit 70 as viewed from a plane including the X-axis and the Y-axis. For convenience of illustration, FIG. 7 illustrates patterns formed in one wiring layer together with the through silicon via T7. In the description of FIG. 7, description that is substantially the same as the description given above with reference to the drawings will be omitted.

As described above with reference to the drawings, a KOZ 71 may be defined by taking into account the impact of the through silicon via T7. The integrated circuit 70 may include a dam structure surrounding the through silicon via T7 in the KOZ 71. For example, as illustrated in FIG. 7, the dam structure may include a first pattern P71 surrounding the through silicon via T7 in the wiring layer. As described below with reference to FIGS. 8A to 8C and FIG. 9, which illustrate examples of cross-sections of the integrated circuit 70, the dam structure may include a plurality of patterns arranged in a plurality of wiring layers and a plurality of vias arranged in via layers between the plurality of wiring layers. Accordingly, interference between signals transmitted through the through silicon via T7 and signals processed by devices arranged adjacent to the KOZ 71 may be eliminated. The dam structure may be formed in the overlapping region 31 of FIG. 3, may be formed along a boundary between the overlapping region 31 and the surrounding region 32, or may be formed in the surrounding region 32. In some implementations, patterns and vias included in the dam structure may be electrically floated.

The integrated circuit 70 may include a plurality of patterns arranged in a plurality of wiring layers and a plurality of vias arranged in via layers between the plurality of wiring layers in a region surrounding the dam structure. For example, as illustrated in FIG. 7, a plurality of patterns including a second pattern P72 may be arranged in a wiring layer, and each of the plurality of patterns may be connected to a pattern of another wiring layer through a via of an upper via layer and/or a lower via layer of the wiring layer. In the present specification, in the region surrounding a dam structure, patterns arranged in a plurality of wiring layers may be referred to as dummy patterns, and vias arranged in a plurality of via layers may be referred to as dummy vias. In some implementations, the dummy patterns may have any shape. For example, as illustrated in FIG. 7, the second pattern P72 as a dummy pattern may have a shape tilted from the X-axis (or Y-axis). In some implementations, the dummy patterns and the dummy vias may be electrically floated. In some implementations, the dummy patterns and the dummy vias may be arranged in the surrounding region 32 of FIG. 3. In some implementations, the dummy patterns and the dummy vias may be insulated from the patterns and the vias included in the dam structure.

FIGS. 8A to 8C are diagrams illustrating examples of a layout of an integrated circuit according to implementations. For example, FIGS. 8A to 8C each illustrate examples of cross-sections taken along line X1-X1' of the integrated circuit 70 of FIG. 7. First to seventh wiring layers M1 to M7 in FIGS. 8A to 8C are only examples, and heights of a through silicon via T8 and a dam structure DAM may also correspond to the height from first to last wiring layers of less than seven or more than seven wiring layers. Hereinafter, FIGS. 8A to 8C will be described with reference to FIG. 7, and any details of the description of FIGS. 8A to 8C overlapping with those provided above will be omitted.

Referring to FIG. 8A, an integrated circuit 80a may include a substrate SUB and may include FEOL, MOL, and BEOL sequentially arranged on the substrate SUB. FEOL may include active patterns, gate electrodes, and a source/drain SD, MOL may include contacts, and BEOL may include metal patterns and vias. The integrated circuit 80a may include the through silicon via T8, and as illustrated in FIG. 8A, the through silicon via T8 may penetrate the substrate SUB in the Z-axis direction. As described above with reference to FIG. 4A, for example, the through silicon via T8 may penetrate the active patterns in the Z-axis direction.

As described above with reference to FIG. 7, the integrated circuit 80a may include the dam structure DAM surrounding the through silicon via T8. As illustrated in FIG. 8A, the dam structure DAM may include metal patterns arranged in the first to seventh wiring layers M1 to M7 and vias arranged in via layers between the first to seventh wiring layers M1 to M7, wherein each of the vias may interconnect adjacent metal patterns to each other (e.g. in the Z-axis direction). Additionally, as described above with reference to FIG. 7, the integrated circuit 80a may include dummy patterns and dummy vias in a region surrounding the dam structure DAM. As illustrated in FIG. 8A, dummy patterns may be arranged in the first to seventh wiring layers M1 to M7, dummy vias may be arranged in via layers between the first to seventh wiring layers M1 to M7, and each of the dummy vias may connect adjacent dummy patterns to each other (e.g. in the Z-axis direction).

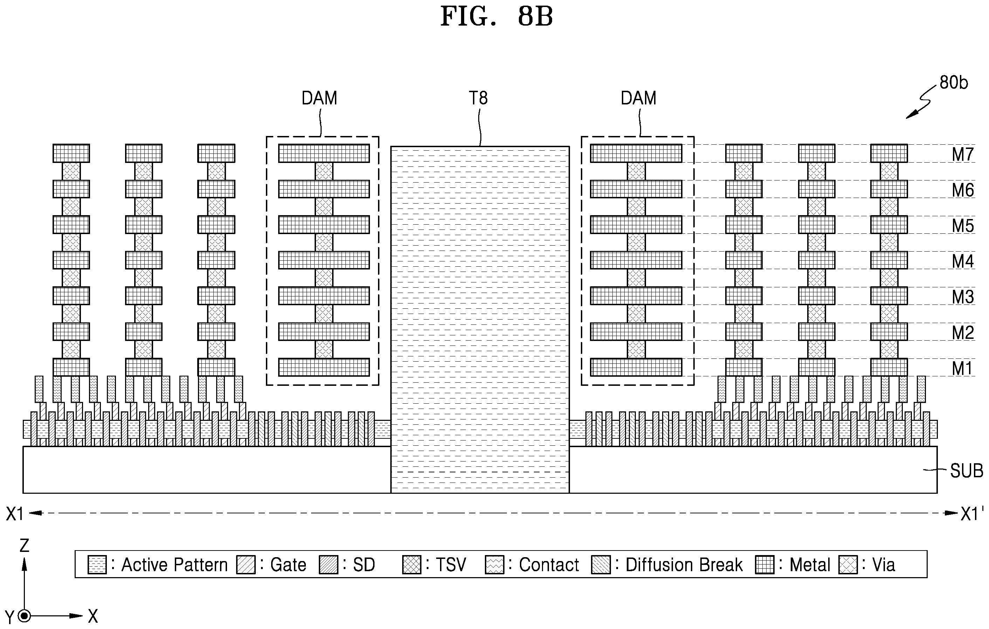

Referring to FIG. 8B, an integrated circuit 80b may include the substrate SUB and may include FEOL, MOL, and BEOL sequentially arranged on the substrate SUB. As illustrated in FIG. 8B, the through silicon via T8 may penetrate not only the substrate SUB but also the active patterns in the Z-axis direction. The integrated circuit 80b may include the dam structure DAM surrounding the through silicon via T8 and may include electrically floating dummy patterns and dummy vias in a region surrounding the dam structure DAM.

Compared to the integrated circuit 80a of FIG. 8A, gate electrodes under the dam structure DAM in the integrated circuit 80b of FIG. 8B may be omitted. That is, the dam structure DAM in FIG. 8B may be arranged in the overlapping region 31 of FIG. 3. For example, as illustrated in FIG. 8B, the gate electrodes may be omitted under the dam structure DAM, and single diffusion breaks may extend in the Y-axis direction. In some implementations, unlike FIGS. 8A and 8B, the dam structure DAM may be positioned along the boundary between the overlapping region 31 and the surrounding region 32 of FIG. 3 so that only some of the gate electrodes may be omitted from below the dam structure DAM.

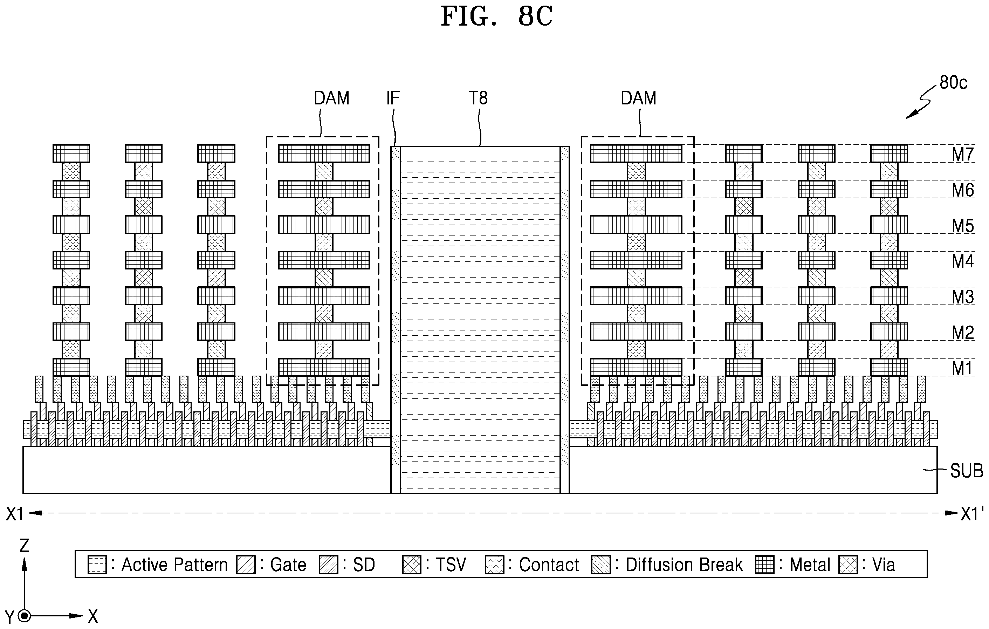

Referring to FIG. 8C, an integrated circuit 80c may include the substrate SUB and may include FEOL, MOL, and BEOL sequentially arranged on the substrate SUB. As illustrated in FIG. 8C, the through silicon via T8 may penetrate not only the substrate SUB but also active patterns in the Z-axis direction. The integrated circuit 80c may include the dam structure DAM surrounding the through silicon via T8 and may include electrically floating dummy patterns and dummy vias in the region surrounding the dam structure DAM. Compared to the integrated circuit 80a of FIG. 8A, the through silicon via T8 in the integrated circuit 80c of FIG. 8C may be surrounded by an insulating film IF including an insulator. Accordingly, the through silicon via T8 may be isolated from other features, such as the active patterns and the substrate SUB.

FIG. 9 is a diagram illustrating a layout of an integrated circuit 90 according to an implementation. For example, FIG. 9 illustrates an example of a cross-section of the integrated circuit 70 of FIG. 7 taken along line Y1-Y1'. The first to seventh wiring layers M1 to M7 in FIG. 9 are only examples, and heights of the through silicon via T8 and the dam structure DAM may also correspond to less than seven or more than seven wiring layers. Hereinafter, FIG. 9 will be described with reference to FIG. 7.

Referring to FIG. 9, the integrated circuit 90 may include the substrate SUB, and the well W may be disposed on the substrate SUB. The integrated circuit 90 may include FEOL, MOL, and BEOL sequentially arranged on the substrate SUB and the well W. FEOL may include active patterns, gate electrodes, and a source/drain SD, MOL may include contacts, and BEOL may include metal patterns and vias. As described above with reference to FIG. 6, the active patterns extending on the well W may have different conductivity types from that of the active patterns extending on the substrate SUB. Additionally, the integrated circuit 90 may include a through silicon via T9, and as illustrated in FIG. 9, the through silicon via T9 may penetrate the substrate SUB in the Z-axis direction. Additionally, as described above with reference to FIG. 4A, etc., the through silicon via T9 may penetrate the active patterns in the Z-axis direction.

As described above with reference to FIG. 7, the integrated circuit 90 may include the dam structure DAM surrounding the through silicon via T9. As illustrated in FIG. 9, the dam structure DAM may include metal patterns arranged in the first to seventh wiring layers M1 to M7 and vias arranged in via layers between the first to seventh wiring layers M1 to M7, wherein each of the vias may interconnect adjacent metal patterns to each other. Additionally, as described above with reference to FIG. 7, the integrated circuit 90 may include dummy patterns and dummy vias in the region surrounding the dam structure DAM. As illustrated in FIG. 9, dummy patterns may be arranged in the first to seventh wiring layers M1 to M7, dummy vias may be arranged in via layers between the first to seventh wiring layers M1 to M7, and each of the dummy vias may connect adjacent dummy patterns to each other (e.g. in the Z-axis direction).

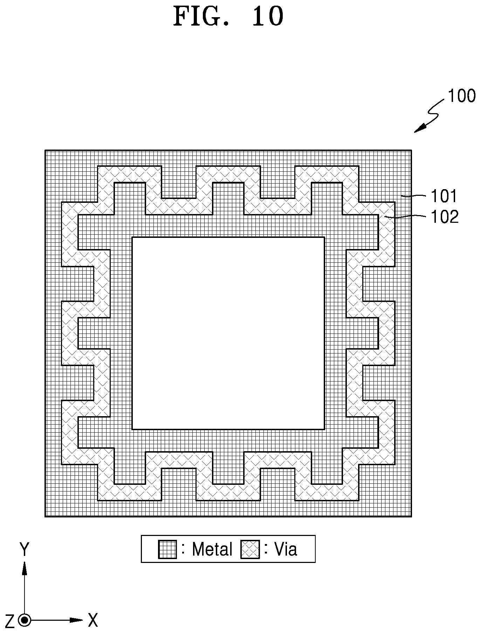

FIG. 10 is a diagram illustrating a dam structure 100 according to an implementation. For example, FIG. 10 illustrates a view of the dam structure 100 as viewed from a plane including the X-axis and the Y-axis. For convenience of illustration, FIG. 10 illustrates a metal pattern 101 arranged in one wiring layer among metal patterns and vias included in the dam structure 100 and a via 102 arranged in an upper via layer of the wiring layer.

As described above with reference to the drawings, an integrated circuit may include the dam structure 100 surrounding a through silicon via, and the dam structure 100 may include metal patterns arranged in a plurality of wiring layers and vias arranged in a plurality of via layers between the plurality of wiring layers. Referring to FIG. 10, the metal pattern 101 may have a shape surrounding a through silicon via and may include portions extending in the X-axis direction and portions extending in the Y-axis direction. The via 102 may also have a shape surrounding a through silicon via.

In some implementations, the via 102 of the dam structure 100 may have a shape that alternately extends in the X-axis direction and the Y-axis direction. For example, as illustrated in FIG. 10, on a portion of the metal pattern 101 extending in the X-axis direction, the via 102 may extend alternately in the X-axis direction and the Y-axis direction, instead of extending only in the X-axis direction. Additionally, on a portion extending in the Y-axis direction of the metal pattern 101, the via 102 may extend alternately in the X-axis direction and the Y-axis direction, instead of extending only in the Y-axis direction. For instance, the via 102 may have a crenelated shape extending around the through silicon via. For instance, the via 102 may have alternating square protrusions and square indentations. Compared to a via having a shape including two portions extending in the X-axis direction and two portions extending in the Y-axis direction, such as the metal pattern 101, the via 102 of FIG. 10 may have high resistance to force applied in the X-axis direction and/or the Y-axis direction, and may stably support the metal pattern 101. In some implementations, the dam structure 100 may have a structure in which metal patterns and vias having the same shapes as the metal pattern 101 and the via 102 of FIG. 10 are stacked.

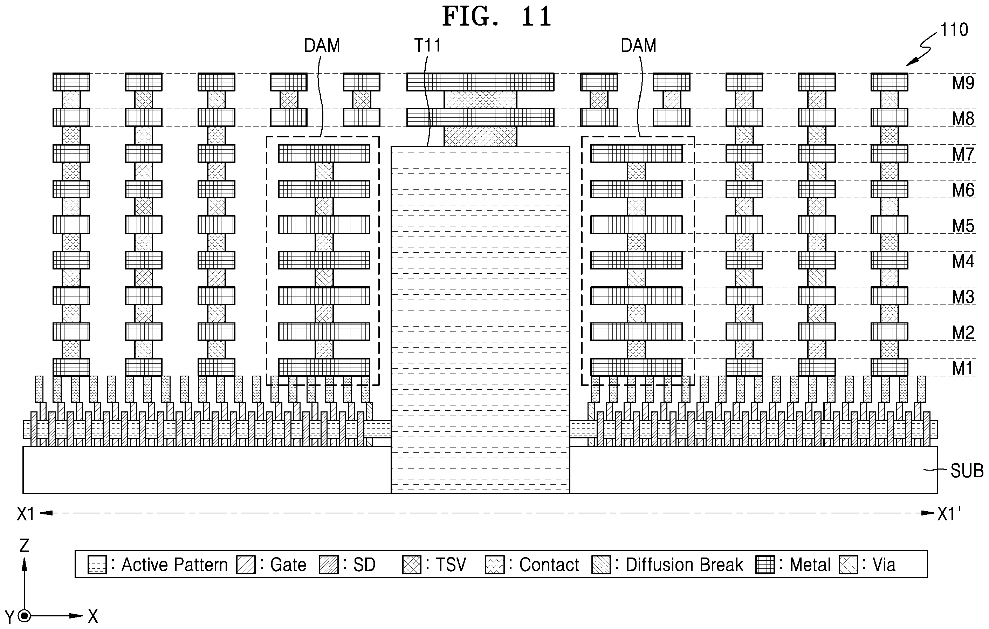

FIG. 11 is a diagram illustrating a layout of an integrated circuit 110 according to an implementation. For example, FIG. 11 illustrates an example of the cross-section of the integrated circuit 70 of FIG. 7 taken along line X1-X1'. A height of a through silicon via T11 and the dam structure DAM in FIG. 9 may also correspond to a height from first to last wiring layers of less than seven or more than seven wiring layers. Hereinafter, FIG. 9 will be described with reference to FIG. 7.

Referring to FIG. 11, the integrated circuit 110 may include the substrate SUB and may include FEOL, MOL, and BEOL sequentially arranged on the substrate SUB. FEOL may include active patterns, gate electrodes, and a source/drain SD, MOL may include contacts, and BEOL may include metal patterns and vias. Additionally, the integrated circuit 110 may include a through silicon via T11, and as illustrated in FIG. 11, the through silicon via T11 may penetrate the substrate SUB in the Z-axis direction. Additionally, as described above with reference to FIG. 4A, etc., the through silicon via T11 may penetrate the active patterns in the Z-axis direction.

As described above with reference to FIG. 7, the integrated circuit 110 may include the dam structure DAM surrounding the through silicon via T11. As illustrated in FIG. 11, the dam structure DAM may include metal patterns arranged in the first to seventh wiring layers M1 to M7 and vias arranged in via layers between the first to seventh wiring layers M1 to M7, wherein each of the vias may interconnect adjacent metal patterns to each other. As with the integrated circuit 80a of FIG. 8A, the integrated circuit 110 may include dummy patterns and dummy vias in a region surrounding a dam structure DAM. Additionally, the integrated circuit 110 may further include dummy patterns and vias arranged on the dam structure DAM. For example, as illustrated in FIG. 11, the integrated circuit 110 may include dummy patterns arranged in an eighth wiring layer M8 and a ninth wiring layer M9 on the dam structure DAM, and may include dummy vias connecting the dummy patterns to each other in a via layer between the eighth wiring layer M8 and the ninth wiring layer M9. Dummy patterns in the eighth wiring layer M8 and the ninth wiring layer M9 may be connected to the dummy patterns in the first to seventh wiring layers M1 to M7. Dummy patterns located above the dam structure DAM may be insulated from (e.g. may not be connected to) the dam structure DAM. Metal patterns may be located in the eighth wiring layer M8 and the ninth witting layer M9 above the through silicon via T11 and may be connected to the through silicon via T11 through a via between the through silicon via T11 and the eighth wiring layer M8.

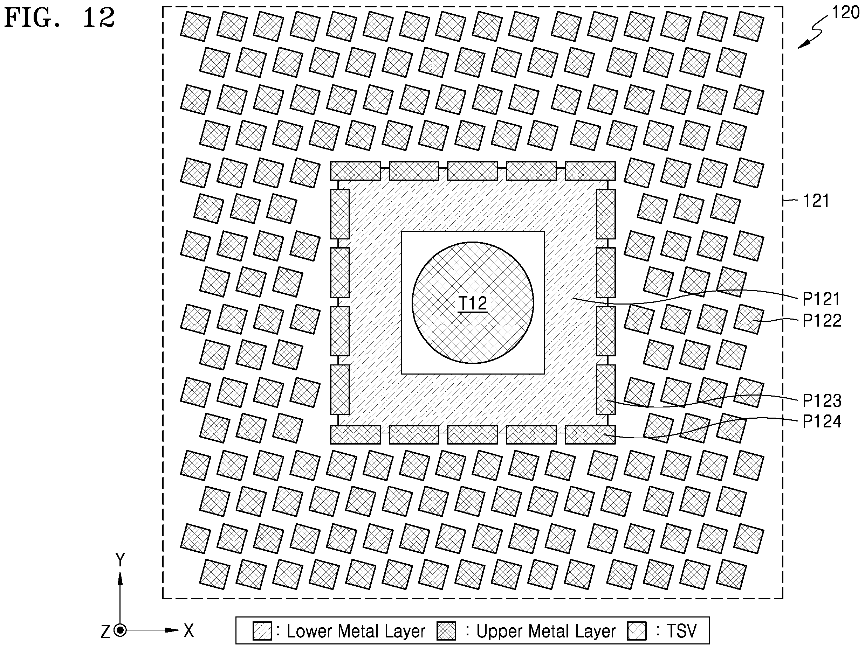

FIG. 12 is a diagram illustrating a layout of an integrated circuit 120 according to an implementation. For example, FIG. 12 illustrates a portion of a layout including a through silicon via T12 in the integrated circuit 120 as viewed from a plane including an X-axis and a Y-axis. For convenience of illustration, FIG. 12 illustrates patterns formed in two wiring layers together with the through silicon via T12. In the description with reference to FIG. 12, description that is substantially the same as the description given above with reference to the drawings will be omitted.

As described above with reference to the drawings, a KOZ 121 may be defined by taking into account the impact of the through silicon via T12. The integrated circuit 120 may include a dam structure surrounding the through silicon via T12 in the KOZ 121, and may include dummy patterns in a region surrounding the dam structure and above the dam structure. For example, as illustrated in FIG. 12, the dam structure may include a metal pattern P121 of a lower wiring layer, and the dummy patterns may be arranged in an upper wiring layer.

In some implementations, dummy patterns proximate to a through silicon via among the dummy patterns may have a different shape from the other dummy patterns. For example, as illustrated in FIG. 12, a dummy pattern P122 may have a shape tilted from the X-axis (or Y-axis) like the second pattern P72 of FIG. 7, while a dummy pattern P123 may have a shape extending in the Y-axis direction, and a dummy pattern P124 may have a shape extending in the X-axis direction.

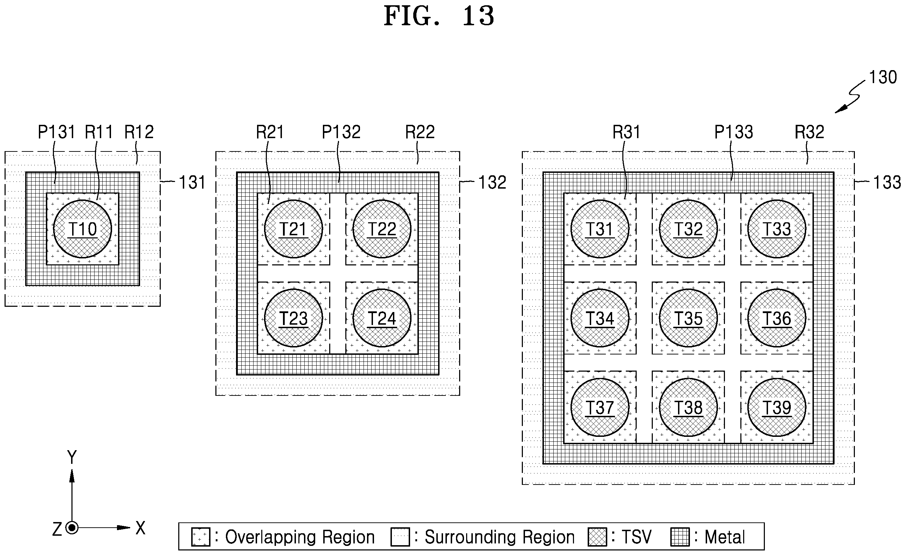

FIG. 13 is a diagram illustrating a layout of an integrated circuit 130 according to an implementation. For example, FIG. 13 illustrates a portion of a layout including through silicon vias, viewed from a plane including the X-axis and the Y-axis. As described above with reference to the drawings, active patterns and diffusion breaks may be arranged in an overlapping region through which a through silicon via penetrates, and gate electrodes as well as the active patterns and the diffusion breaks may be arranged in a surrounding region surrounding the overlapping region. Additionally, the dam structure surrounding the through silicon vias may include a plurality of metal patterns and a plurality of vias that are stacked. As illustrated in FIG. 13, the integrated circuit 130 may include a single, independent through silicon via, or may include a through silicon via array including two or more through silicon vias.

The integrated circuit 130 may include a first KOZ 131 for one through silicon via T10. For example, as illustrated in FIG. 13, the first KOZ 131 may include an overlapping region R11 and a surrounding region R12 surrounding the overlapping region R11. Additionally, a dam structure including a metal pattern P131 in the first KOZ 131 may surround the through silicon via T10.

The integrated circuit 130 may include a KOZ for a through silicon via array including a plurality of through silicon vias. For example, as illustrated in FIG. 13, in a similar manner to the overlapping region R21 corresponding to the through silicon via T21, a second KOZ 132 for four through silicon vias T21 to T24 may include four overlapping regions respectively corresponding to the four through silicon vias T21 to T24, and may include a surrounding region R22 surrounding the four overlapping regions. Additionally, a dam structure including a metal pattern P132 in the second KOZ 132 may surround the four through silicon vias T21 to T24. Additionally, as with an overlapping region R31 corresponding to the through silicon via T31, a third KOZ 133 for nine through silicon vias T31 to T39 may include nine overlapping regions respectively corresponding to the nine through silicon vias T31 to T39, and may include a surrounding region R32 surrounding the nine overlapping regions. Additionally, a dam structure including a metal pattern P133 in the third KOZ 133 may surround the nine through silicon vias T31 to T39.

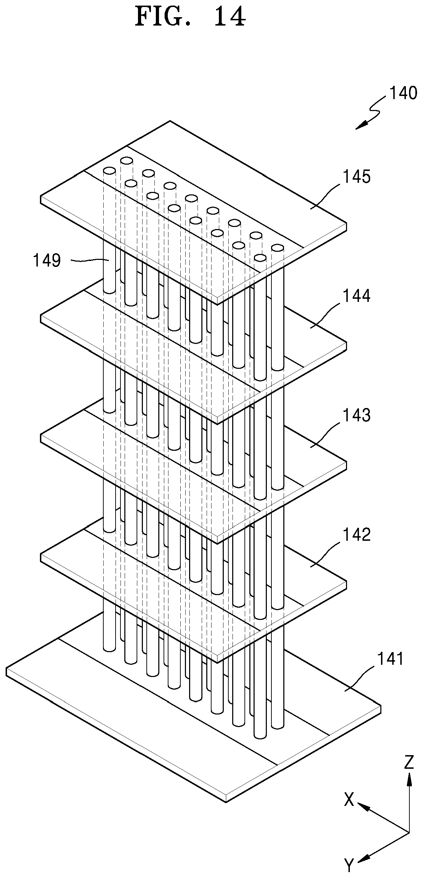

FIG. 14 is a diagram illustrating a memory device 140 according to an implementation. The memory device 140 may include chips that are stacked, each of which may include a structure for a through silicon via as described above with reference to the drawings. Accordingly, the memory device 140 may provide the designed performance and have high area efficiency and reliability.

Referring to FIG. 14, the memory device 140 may include first to fifth chips 141 to 145 that are stacked. The first chip 141 may be an interface chip, and the second to fifth chips 142 to 145 may be memory chips. As illustrated in FIG. 14, the first to fifth chips 141 to 145 may be interconnected through through silicon vias 149. Each of the second to fifth chips 142 to 145 may include a memory cell array, and the first chip 141 may include a circuit that provides an interface between the second to fifth chips 142 to 145 and the outside of the memory device 140. Due to the memory chips being interconnected with through silicon vias, the memory device 140 may provide high bandwidth and may be referred to as high bandwidth memory (HBM).

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. An integrated circuit comprising:
a plurality of first active patterns positioned in a first region of a substrate and extending in a first horizontal direction;
a through silicon via positioned in the first region, the through silicon via vertically extending though the substrate and at least one of the plurality of first active patterns; and
a plurality of first diffusion breaks positioned in the first region, the plurality of first diffusion breaks extending in a second horizontal direction and dividing the plurality of first active patterns.

2. The integrated circuit of claim 1, further comprising:
a plurality of gate electrodes extending in the second horizontal direction within a second region surrounding the first region,
wherein the first region is free of the plurality of gate electrodes.

3. The integrated circuit of claim 2, wherein a pitch of the plurality of first diffusion breaks is different from a pitch of the plurality of gate electrodes.

4. The integrated circuit of claim 2 or claim 3, further comprising:
a via zone including the first region and the second region, wherein the plurality of gate electrodes are a plurality of first gate electrodes; and
a device zone surrounding the via zone, wherein the device zone comprises:
a plurality of second gate electrodes, a pitch of the plurality of second gate electrodes being equal to a pitch of the plurality of first gate electrodes; and
a plurality of fourth active patterns, a pitch of the plurality of fourth active patterns being equal to a pitch of the plurality of first active patterns.

5. The integrated circuit of any of claims 2-4, wherein the second region includes a first sub-region adjacent to the first region in the second horizontal direction and a second sub-region adjacent to the first region in the first horizontal direction, and
wherein the integrated circuit further comprises:
a plurality of second active patterns extending in the first horizontal direction in the first sub-region; and
a plurality of third active patterns extending in the first horizontal direction in the second sub-region,
wherein the plurality of second active patterns have a conductivity type different from a conductivity type of the plurality of first active patterns.

6. The integrated circuit of claim 5, further comprising:
a well located on the substrate in the first sub-region, the well having a conductivity type that is the same as the conductivity type of the plurality of first active patterns,
wherein the plurality of second active patterns extend on the well in the first horizontal direction.

7. The integrated circuit of any of claims 2-6, further comprising: a second diffusion break extending in the second horizontal direction and positioned at an outer boundary of the second region,
wherein the second diffusion break has a width greater than a width of each of the plurality of first diffusion breaks.

8. The integrated circuit of any of claims 2-7, further comprising:
a plurality of first patterns positioned in the second region, the plurality of first patterns arranged in a plurality of wiring layers over the plurality of gate electrodes, the plurality of first patterns being electrically insulated from each other; and
a plurality of first vias positioned in the second region, the plurality of first vias arranged in a plurality of via layers between corresponding wiring layers of the plurality of wiring layers, the plurality of first vias being electrically insulated from each other.

9. The integrated circuit of claim 8, further comprising:
a dam structure surrounding the through silicon via, the dam structure being between the through silicon via and the plurality of first patterns,
wherein the dam structure includes a plurality of second patterns respectively arranged in the plurality of wiring layers and a plurality of second vias arranged in the plurality of via layers, and
each of the plurality of second vias interconnects two adjacent second patterns of the plurality of second patterns.

10. An integrated circuit comprising:
a through silicon via that vertically extends through a substrate; and
a dam structure surrounding the through silicon via,
wherein the dam structure includes a plurality of first patterns respectively arranged in a plurality of wiring layers over the substrate and a plurality of first vias respectively arranged in a plurality of via layers between corresponding wiring layers of the plurality of wiring layers, and
each of the plurality of first vias interconnects two adjacent first patterns of the plurality of first patterns.

11. The integrated circuit of claim 10, wherein each of the plurality of first patterns surrounds the through silicon via, and
each of the plurality of first vias surrounds the through silicon via.

12. The integrated circuit of claim 11, wherein each of the plurality of first vias extends alternately in a first horizontal direction and a second horizontal direction.

13. The integrated circuit of any of claims 10-12, wherein the plurality of first patterns and the plurality of first vias are electrically floated.

14. The integrated circuit of any of claims 10-13, further comprising:
a plurality of second patterns arranged in the plurality of wiring layers and positioned in a region surrounding the dam structure; and
a plurality of second vias arranged in the plurality of via layers and positioned in the region,
wherein the plurality of second patterns and the plurality of second vias are electrically floated.

15. The integrated circuit of claim 14, wherein the plurality of first patterns and the plurality of first vias are insulated from the plurality of second patterns and the plurality of second vias, respectively.
